# EUROPEAN PATENT APPLICATION

(11) **EP 4 300 587 A1**
(43) Date of publication of application: **03.01.2024**
(21) Application number: 22766220.2
(22) Date of filing: 03.03.2022
(51) Int. Cl.: H01L 29/06, H01L 29/20, H01L 21/335

(54) **FIELD EFFECT TRANSISTOR, MANUFACTURING METHOD THEREFOR, AND SWITCHING CIRCUIT**

(30) Priority: 09.03.2021 CN 202110256517
(71) Applicant: Huawei Technologies Co., Ltd., Shenzhen, Guangdong 518129 (CN)
(72) Inventor: BAO, Qilong, Shenzhen, Guangdong 518129 (CN); JIANG, Qimeng, Shenzhen, Guangdong 518129 (CN); TANG, Gaofei, Shenzhen, Guangdong 518129 (CN); WANG, Hanxing, Shenzhen, Guangdong 518129 (CN); CURATOLA, Gilberto, Shenzhen, Guangdong 518129 (CN)
(74) Representative: Huawei European IPR
(86) International application number: PCT/CN2022/079143
(87) International publication number: WO 2022/188694

(57) **Abstract**

This application provides a field effect transistor, a method for preparing the field effect transistor, and a switch circuit. The field effect transistor includes a channel layer, a source, a drain, a gate structure, and a gate metal layer; and the gate structure includes a P-type gallium nitride layer and an N-type gallium nitride layer that are disposed in a stacking manner, so that a gate metal/pGaN Schottky diode is replaced with an nGaN/pGaN reverse bias diode, to improve a gate voltage-withstand capability of the field effect transistor, thereby improving a breakdown capability of the field effect transistor. A doping density of the P-type gallium nitride layer is between 1 × 10¹⁸ cm⁻³ and 1 x 10¹⁹ cm⁻³, so that a charge storage effect during operation of a device can be reduced, carriers at the pGaN layer can be exhausted as much as possible, and redundant-charge storage is avoided, thereby improving operating threshold voltage stability of the device. The gate metal layer is in ohmic contact with the gate structure, so that reliability of a connection between the gate metal layer and the gate structure can be improved, thereby improving reliability of the field effect transistor.

## Description

### CROSS-REFERENCE TO RELATED APPLICATIONS

This application claims priority to the Chinese Patent Application No. 202110256517.7, filed with the China National Intellectual Property Administration on March 9, 2021 and entitled "FIELD EFFECT TRANSISTOR, PREPARATION METHOD THEREOF, AND SWITCH CIRCUIT", which is incorporated herein by reference in its entirety.

### TECHNICAL FIELD

This application relates to the field of semiconductor technologies, and in particular, to a field effect transistor, a method for preparing the field effect transistor, and a switch circuit.

### BACKGROUND

A field effect transistor is widely used as a component of a circuit switch in various scenarios. A field effect transistor made of GaN (gallium nitride) series materials, with high mobility and high chemical stability due to its material characteristics, can be used as a higher-frequency switch.

A GaN field effect transistor is switched on or off by controlling connection and cutoff of two-dimensional electron gas of a channel. GaN field effect transistors are generally classified into two types: normally-open field effect transistors that are also referred to as depletion-mode field effect transistors, and normally-closed field effect transistors that are also referred to as enhanced field effect transistors. However, in consideration of safety of a power consumption system, a switch device is generally required to be a normally-closed device. Currently, there are a plurality of manners of implementing a normally-closed switch device.

A GaN field effect transistor provided in a current technology includes a channel layer, a source, a drain, a gate structure, and a gate metal layer. During use, the gate metal layer supplies power to the gate structure, and conduction of the source and the drain is controlled by using the gate structure. However, the gate metal layer is generally in Schottky contact with the gate structure, and two back-to-back diodes are formed in the GaN field effect transistor. It is difficult to discharge a charge, and consequently, a threshold voltage of the field effect transistor is unstable. In addition, a Schottky diode between the gate metal layer and the gate structure is prone to break down when the gate metal layer withstands a relatively high voltage under a condition of a positive voltage bias.

### SUMMARY

This application provides a field effect transistor, a method for preparing the field effect transistor, and a switch circuit, to improve threshold voltage stability and a breakdown capability of the field effect transistor.

According to a first aspect, a field effect transistor is provided, where the field effect transistor is applied in a switch circuit and used as a main component of the switch circuit, and is configured to control connection and disconnection of the switch circuit. The field effect transistor includes a channel layer, a source, a drain, a gate structure, and a gate metal layer. The field effect transistor successively includes: a channel layer; a source, a drain, and a gate structure that are located on the channel layer and disposed at a same layer; and a gate metal layer located on the gate structure. The gate structure includes a P-type gallium nitride (pGaN) layer and an N-type gallium nitride (nGaN) layer that are disposed in a stacking manner, where the pGaN layer is located between the nGaN layer and the channel layer. In this way, an nGaN/pGaN reverse bias diode is used to replace a gate metal/pGaN Schottky diode in a current technology to withstand a voltage, so that a gate voltage-withstand capability of the field effect transistor can be greatly increased, thereby improving a breakdown capability of the field effect transistor. In addition, the gate metal layer is in ohmic contact with the nGaN layer. Forming ohmic contact between metal and a semiconductor means that a pure resistor is at a contact point, and smaller resistance is better, so that when a component is operated, most voltages are applied to an active area instead of a contact surface. In addition, the ohmic contact does not involve long-term thermo-electron bombardment, and is highly reliable. The gate metal layer is in ohmic contact with the gate structure, so that reliability of a connection between the gate metal layer and the gate structure can be improved, thereby improving reliability of the field effect transistor. In the gate structure, a doping element of the pGaN layer may be magnesium (Mg) or the like, and a doping density of the pGaN layer is controlled between 1 × 10¹⁸ cm⁻³ and 1 × 10¹⁹ cm⁻³, so that a charge storage effect during operation of a device can be reduced, carriers in the pGaN layer are exhausted as much as possible, and redundant-charge storage is avoided, thereby improving operating threshold voltage stability of the device.

Further, to reduce a charge storage effect during operation of the device, a thickness of the pGaN layer may be reduced. In this application, the thickness of the pGaN layer is controlled to be between 50 nm and 70 nm, for example, 50 nm, 55 nm, 60 nm, 65 nm, or 70 nm. This is not limited herein.

In the gate structure, a doping element of the nGaN layer may be silicon (Si), germanium (Ge), or the like, and a doping density of the nGaN layer is controlled between 1 × 10¹⁶ cm⁻³ and 5 x 10¹⁹ cm⁻³, so that a charge storage effect during operation of a device is reduced, carriers in the pGaN layer are exhausted as much as possible, and redundant-charge storage is avoided, thereby improving operating threshold voltage stability of the device.

During specific implementation, a thickness of the nGaN layer may be less than or equal to 40 nm. This is not limited herein.

The field effect transistor may further include a substrate and a buffer layer disposed on the substrate, where the channel layer is formed on the buffer layer. The substrate is a basic component of the field effect transistor, and is configured to carry each function layer of the field effect transistor. In specific disposition, the substrate may be made of different materials, provided that the substrate has a specific support strength. For example, the substrate may be made of a material such as silicon, sapphire, silicon carbide, or gallium nitride, that is, the substrate may be made of different materials.

In an optional solution, a rectangular structure layer may be selected as the substrate. However, it needs to be understood that, a shape of the substrate provided in embodiments of this application is not limited to a rectangular structure, and another shape such as an ellipse or a polygon may be used, provided that there is a sufficient area to carry another function layer of the field effect transistor.

The buffer layer is disposed on the substrate, and may be specifically formed on a surface of the substrate by using a process such as chemical vapor deposition or epitaxial growth. The buffer layer serves as an optional structural layer. The buffer layer may be disposed based on a requirement. For example, when the substrate can directly carry the channel layer, the buffer layer may not be disposed, and the channel layer may be directly formed on the substrate; or when a material of the channel layer conflicts with that of the substrate, and the channel layer cannot be directly formed on the substrate, the buffer layer is disposed to isolate the substrate from the channel layer. In this case, the buffer layer is used as a bearer layer of the channel layer. When the buffer layer carries the channel layer, on one hand, the buffer layer can be used as a structural layer for carrying the channel layer; and on the other hand, the buffer layer further has elastic deformation performance to some extent and can protect the channel layer disposed on a surface of the buffer layer, thereby improving reliability and safety of the field effect transistor provided in embodiments of this application.

In an optional solution, the buffer layer may be made of a material such as gradient aluminum gallium nitride, super-lattice, or low-temperature aluminum nitride. During specific preparation of the field effect transistor, different materials may be selected based on a requirement to prepare the buffer layer.

As a function layer of the field effect transistor, the channel layer is configured to form two-dimensional electron gas of the field effect transistor. In an optional solution, the channel layer includes a gallium nitride (GaN) layer and an aluminum gallium nitride (AlGaN) barrier layer that are disposed in a stacking manner. A channel can be formed on a contact surface between the GaN layer and the AlGaN barrier layer, and the two-dimensional electron gas is located on the contact surface between the GaN layer and the AlGaN barrier layer.

During specific disposition of the channel layer, the GaN layer may be disposed on the buffer layer, for example, may be directly formed on the buffer layer by using an etching or ion injection process. When the substrate can directly carry the channel layer, that is, when the buffer layer is not included, the GaN layer may be directly prepared on the substrate by using a process such as etching or ion injection. The AlGaN barrier layer is disposed on a surface that is of the GaN layer and that is away from the substrate. During preparation, the AlGaN barrier layer may be prepared also by using the foregoing process such as etching or ion injection.

In addition to the foregoing structure, the channel layer may further use another structure. For example, the channel layer includes a three-layer structure: a gallium nitride layer, an aluminum gallium nitride barrier layer, and an aluminum nitride layer located between the gallium nitride layer and the aluminum gallium nitride barrier layer. A channel can also be formed by using the three-layer structure.

The source, the drain, and the gate structure disposed at the same layer are functional layers of the field effect transistor. The source, the gate structure, and the drain are disposed on the channel layer and at the same layer, and are electrically connected to the channel layer. The source and the drain are respectively configured to connect to an external circuit, and the gate structure is configured to control connection and disconnection of a channel. When the gate structure controls the channel to be connected, the field effect transistor is in a closed state, and the circuit connected to the source and the drain can be connected; or when the gate structure controls the channel to be disconnected, the field effect transistor is in a cutoff state, and the circuit connected to the source and the drain is in a disconnected state.

The gate structure, the source, and the drain are respectively connected to the AlGaN barrier layer, and the source and the drain can be connected to the channel by using the AlGaN barrier layer. The gate structure can be connected to the channel by using the AlGaN barrier layer, and can absorb electrons located in the channel. When the gate structure controls the channel to be connected, electrons are located in the channel, and the source and the drain can be conducted by using electrons in the channel. When the gate structure controls the channel to be disconnected, electrons are absorbed by the gate structure, leaving no free electron in the channel, and the source and the drain are cut off.

During specific disposition of the source, the drain, and the gate structure, the gate structure is located between the source and the drain, and separates the source from the drain. It needs to be understood that, during specific disposition of the gate structure, the drain, and the source, the gate structure, the source, and the drain are disposed at intervals, to ensure electrical isolation between the gate structure, the source, and the drain.

In the field effect transistor, the gate metal layer is configured to connect to the gate structure, and is configured to apply, to the gate structure, a control voltage for controlling channel connection and disconnection.

Optionally, the field effect transistor may further include a passivation layer, where the passivation layer is configured to protect each functional layer in the field effect transistor. During disposition, the passivation layer is disposed in a manner of stacking with the aluminum gallium nitride barrier. It needs to be understood that, to ensure that the source, the drain, and the gate structure can be connected to an external circuit and a control circuit, during disposition of the foregoing structures, the source, the drain, and the gate structure pass through the passivation layer and are exposed from the passivation layer. Exposed parts of the source, the drain, and the gate structure can be configured to connect to the external circuit and the control circuit.

In an optional solution, the passivation layer may be prepared by using silicon nitride, aluminum oxide, silicon oxynitride, or another insulation material.

It needs to be understood that the passivation layer is an optional structural layer of the field effect transistor. When an application environment of the field effect transistor is relatively safe, the passivation layer may not be disposed.

According to a second aspect, a method for preparing a field effect transistor is provided. The method includes the following steps: first forming a channel layer;
then forming a gate structure on the channel layer, where the gate structure includes a P-type gallium nitride layer and an N-type gallium nitride layer that are disposed in a stacking manner, the P-type gallium nitride layer is located between the N-type gallium nitride layer and the channel layer, and a doping density of the P-type gallium nitride layer is between 1 × 10¹⁸ cm⁻³ and 1 × 10¹⁹ cm⁻³; and then forming a source and a drain on the channel layer, and forming a gate metal layer on the gate structure.

In an optional solution, a thickness of the P-type gallium nitride layer is greater than or equal to 50 nm and less than or equal to 70 nm.

According to a third aspect, a switch circuit is provided, where the switch circuit includes a mainboard and a field effect transistor that is disposed on the mainboard and that is any one of the foregoing field effect transistors.

### BRIEF DESCRIPTION OF DRAWINGS

FIG. 1 is a schematic diagram of a structure of a field effect transistor according to an embodiment of this application;
FIG. 2 is a schematic diagram of a structure of a field effect transistor according to another embodiment of this application;
FIG. 3 is a flowchart of a method for preparing a field effect transistor according to an embodiment of this application;
FIG. 4a to FIG. 4c are schematic structural diagrams of a process of preparing a field effect transistor according to an embodiment of this application;
FIG. 5 is a flowchart of a method for preparing a field effect transistor according to still another embodiment of this application; and
FIG. 6 is a schematic structural diagram of a process of preparing a field effect transistor according to an embodiment of this application.

### DESCRIPTION OF EMBODIMENTS

To make the objectives, technical solutions, and advantages of this application clearer, the following further describes this application in detail with reference to the accompanying drawings.

A field effect transistor provided in embodiments of this application is widely used as a component of a circuit switch in various scenarios. A field effect transistor made of GaN (gallium nitride) series materials, with high mobility and high chemical stability due to its material characteristics, can be used as a higher-frequency switch and therefore is widely used in a highfrequency circuit switch.

A GaN field effect transistor is switched on or off by controlling connection and cutoff of two-dimensional electron gas of a channel. GaN field effect transistors are generally classified into two types: normally-open field effect transistors that are also referred to as depletion-mode field effect transistors, and normally-closed field effect transistors that are also referred to as enhanced field effect transistors. However, in consideration of safety of a power consumption system, a switch device is generally required to be a normally-closed device. Currently, there are a plurality of manners of implementing a normally-closed switch device. However, generally a Schottky junction manner is used for connection between a gate metal layer and a gate structure of a current GaN field effect transistor, and two back-to-back diodes are formed in the GaN field effect transistor. It is difficult to discharge a charge, and consequently, a threshold voltage of the field effect transistor is unstable. In addition, a Schottky diode between the gate metal layer and the gate structure is prone to break down when the gate metal layer withstands a relatively high voltage under a condition of a positive voltage bias.

Therefore, an embodiment of this application provides a field effect transistor to improve threshold voltage stability and a breakdown capability of a device. The following describes the field effect transistor in detail with reference to specific accompanying drawings and embodiments.

Terms used in the following embodiments are merely intended to describe particular embodiments, but are not intended to limit this application. As used in this specification and appended claims of this application, singular expressions "one", "a", "the", "the foregoing", "this", and "the one" are also intended to include expressions such as "one or more", unless the contrary is clearly indicated in its context.

Reference to "an embodiment", "some embodiments", or the like described in this specification indicates that one or more embodiments of this application include a specific feature, structure, or characteristic described with reference to the embodiment or embodiments. Therefore, statements such as "in an embodiment", "in some embodiments", "in some other embodiments", and "in other embodiments" that appear at different places in this specification do not necessarily mean reference to a same embodiment, instead, they mean "one or more but not all of embodiments", unless otherwise specifically emphasized. The terms "include", "comprise", "have", and their variants all mean "include but are not limited to", unless otherwise specifically emphasized.

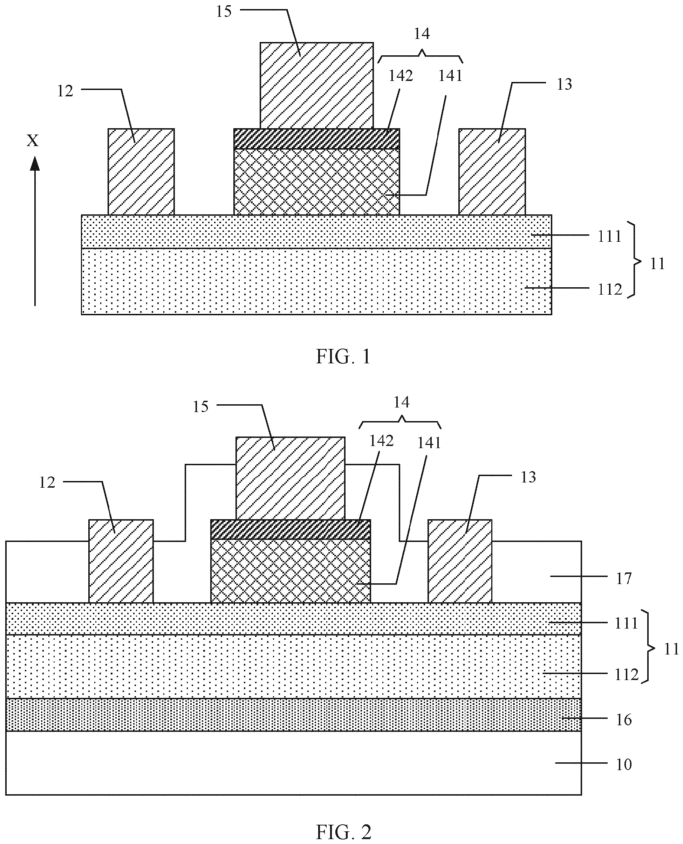

FIG. 1 is a schematic diagram of a structure of a field effect transistor according to an embodiment of this application. The field effect transistor provided in this embodiment of this application includes a channel layer 11, a source 12, a drain 13, a gate structure 14, and a gate metal layer 15. For ease of description, a placement direction of the field effect transistor shown in FIG. 1 is used as a reference direction. Along a direction X, the field effect transistor sequentially includes: a channel layer 11; a source 12, a drain 13, and a gate structure 14 that are located on the channel layer 11 and disposed at a same layer; and a gate metal layer 15 located on the gate structure 14. The gate structure 14 includes a P-type gallium nitride (pGaN) layer 141 and an N-type gallium nitride (nGaN) layer 142 that are disposed in a stacking manner, and the pGaN layer 141 is located between the nGaN layer 142 and the channel layer 11. In this way, an nGaN/pGaN reverse bias diode is used to replace a gate metal/pGaN Schottky diode in a current technology to withstand a voltage, so that a gate voltage-withstand capability of the field effect transistor can be greatly increased, thereby improving a breakdown capability of the field effect transistor.

In addition, the gate metal layer 15 is in ohmic contact with the nGaN layer 142. Forming ohmic contact between metal and a semiconductor means that a pure resistor is at a contact point, and smaller resistance is better, so that when a component is operated, most voltages are applied to an active area instead of a contact surface. In addition, the ohmic contact does not involve long-term thermo-electron bombardment, and is highly reliable. The gate metal layer is in ohmic contact with the gate structure, so that reliability of a connection between the gate metal layer and the gate structure can be improved, thereby improving reliability of the field effect transistor.

In the gate structure 14, a doping element of the pGaN layer 141 may be magnesium (Mg) or the like, and a doping density of the pGaN layer 141 is controlled between 1 × 10¹⁸ cm⁻³ and 1 × 10¹⁹ cm⁻³, so that a charge storage effect during operation of a device can be reduced, carriers in the pGaN layer 141 are exhausted as much as possible, and redundant-charge storage is avoided, thereby improving operating threshold voltage stability of the device.

Further, to reduce a charge storage effect during operation of the device, a thickness of the pGaN layer may be reduced. In this application, the thickness of the pGaN layer is controlled to be between 50 nm and 70 nm, for example, 50 nm, 55 nm, 60 nm, 65 nm, or 70 nm. This is not limited herein.

In the gate structure 14, a doping element of the nGaN layer 142 may be silicon (Si), germanium (Ge), or the like, and a doping density of the nGaN layer 142 is controlled between 1 x 10¹⁶ cm⁻³ and 5 x 10¹⁹ cm⁻³, so that a charge storage effect during operation of a device is reduced, carriers in the pGaN layer are exhausted as much as possible, and redundant-charge storage is avoided, thereby improving operating threshold voltage stability of the device.

During specific implementation, a thickness of the nGaN layer 142 may be less than or equal to 40 nm. This is not limited herein.

Refer to FIG. 2. The field effect transistor may further include a substrate 10 and a buffer layer 16 disposed on the substrate 10, where the channel layer 11 is formed on the buffer layer 16. The substrate 10 is a basic component of the field effect transistor, and is configured to carry each function layer of the field effect transistor. In specific disposition, the substrate 10 may be made of different materials, provided that the substrate 10 has a specific support strength. For example, the substrate 10 may be made of a material such as silicon, sapphire, silicon carbide, or gallium nitride, that is, the substrate 10 may be made of different materials.

In an optional solution, a rectangular structure layer may be selected as the substrate 10. However, it needs to be understood that, a shape of the substrate 10 provided in embodiments of this application is not limited to a rectangular structure, and another shape such as an ellipse or a polygon may be used, provided that there is a sufficient area to carry another function layer of the field effect transistor.

The buffer layer 16 is disposed on the substrate 10, and may be specifically formed on a surface of the substrate 10 by using a process such as chemical vapor deposition or epitaxial growth. The buffer layer 16 serves as an optional structural layer. The buffer layer 16 may be disposed based on a requirement. For example, when the substrate 10 can directly carry the channel layer 11, the buffer layer 16 may not be disposed, and the channel layer 11 may be directly formed on the substrate 10; or when a material of the channel layer 11 conflicts with that of the substrate 10, and the channel layer 11 cannot be directly formed on the substrate 10, the buffer layer 16 is disposed to isolate the substrate 10 from the channel layer 11. In this case, the buffer layer 16 is used as a bearer layer of the channel layer 11. When the buffer layer 16 carries the channel layer 11, on one hand, the buffer layer 16 can be used as a structural layer for carrying the channel layer 11; and on the other hand, the buffer layer 16 further has elastic deformation performance to some extent, and the buffer layer 16 can protect the channel layer 11 disposed on a surface of the buffer layer 16, thereby improving reliability and safety of the field effect transistor provided in embodiments of this application.

In an optional solution, the buffer layer 16 may be made of a material such as gradient aluminum gallium nitride, super-lattice, or low-temperature aluminum nitride. During specific preparation of the field effect transistor, different materials may be selected based on a requirement to prepare the buffer layer 16.

As a function layer of the field effect transistor, the channel layer 11 is configured to form two-dimensional electron gas of the field effect transistor. In an optional solution, the channel layer 11 includes a gallium nitride (GaN) layer 112 and an aluminum gallium nitride (AlGaN) barrier layer 111 that are stacked along the X direction. A channel can be formed on a contact surface between the GaN layer 112 and the AlGaN barrier layer 111, and the two-dimensional electron gas is located on the contact surface between the GaN layer 112 and the AlGaN barrier layer 111.

During specific disposition of the channel layer 11, the GaN layer 112 may be disposed on the buffer layer 16, for example, may be directly formed on the buffer layer 16 by using an etching or ion injection process. When the substrate 10 can directly carry the channel layer 11, that is, when the buffer layer 16 is not included, the GaN layer 112 may be directly prepared on the substrate 10 by using a process such as etching or ion injection. The AlGaN barrier layer 111 is disposed on a surface that is of the GaN layer 112 and that is away from the substrate 10. During preparation, the AlGaN barrier layer 111 may be prepared also by using the foregoing process such as etching or ion injection.

In addition to the foregoing structure, the channel layer 11 may further use another structure. For example, the channel layer 11 includes a three-layer structure: a gallium nitride layer, an aluminum gallium nitride barrier layer, and an aluminum nitride layer located between the gallium nitride layer and the aluminum gallium nitride barrier layer. A channel can also be formed by using the three-layer structure.

The source 12, the drain 13, and the gate structure 14 disposed at the same layer are functional layers of the field effect transistor. As shown in FIG. 1, the source 12, the gate structure 14, and the drain 13 are disposed on the channel layer 11 and at the same layer, and are electrically connected to the channel layer 11. The source 12 and the drain 13 are respectively configured to connect to an external circuit, and the gate structure 14 is configured to control connection and disconnection of a channel. When the gate structure 14 controls the channel to be connected, the field effect transistor is in a closed state, and the circuit connected to the source 12 and the drain 13 can be connected; or when the gate structure 14 controls the channel to be disconnected, the field effect transistor is in a cutoff state, and the circuit connected to the source 12 and the drain 13 is in a disconnected state.

The gate structure 14, the source 12, and the drain 13 are respectively connected to the AlGaN barrier layer 111, and the source 12 and the drain 13 can be connected to the channel by using the AlGaN barrier layer 111. The gate structure 14 can be connected to the channel by using the AlGaN barrier layer 111, and can absorb electrons located in the channel. When the gate structure 14 controls the channel to be connected, electrons are located in the channel, and the source 12 and the drain 13 can be conducted by using electrons in the channel. When the gate structure 14 controls the channel to be disconnected, electrons are absorbed by the gate structure 14, leaving no free electron in the channel, and the source 12 and the drain 13 are cut off.

During specific disposition of the source 12, the drain 13, and the gate structure 14, the gate structure 14 is located between the source 12 and the drain 13, and separates the source 12 from the drain 13. It needs to be understood that, during specific disposition of the gate structure 14, the drain 13, and the source 12, the gate structure 14, the source 12, and the drain 13 are disposed at intervals, to ensure electrical isolation between the gate structure 14, the source 12, and the drain 13.

In the field effect transistor, the gate metal layer 15 is configured to connect to the gate structure 14, and is configured to apply, to the gate structure 14, a control voltage for controlling channel connection and disconnection.

Refer to FIG. 2 again. The field effect transistor further includes a passivation layer 17, where the passivation layer 17 is configured to protect each function layer in the field effect transistor. During disposition, the passivation layer 17 is disposed in a manner of stacking with the aluminum gallium nitride barrier layer 111. It needs to be understood that, to ensure that the source 12, the drain 13, and the gate structure 14 can be connected to an external circuit and a control circuit, during disposition of the foregoing structures, the source 12, the drain 13, and the gate structure 14 pass through the passivation layer 17 and are exposed from the passivation layer 17. Exposed parts of the source 12, the drain 13, and the gate structure 14 can be configured to connect to the external circuit and the control circuit.

In an optional solution, the passivation layer 17 may be prepared by using silicon nitride, aluminum oxide, silicon oxynitride, or another insulation material.

It needs to be understood that the passivation layer 17 is an optional structural layer of the field effect transistor. When an application environment of the field effect transistor is relatively safe, the passivation layer 17 may not be disposed.

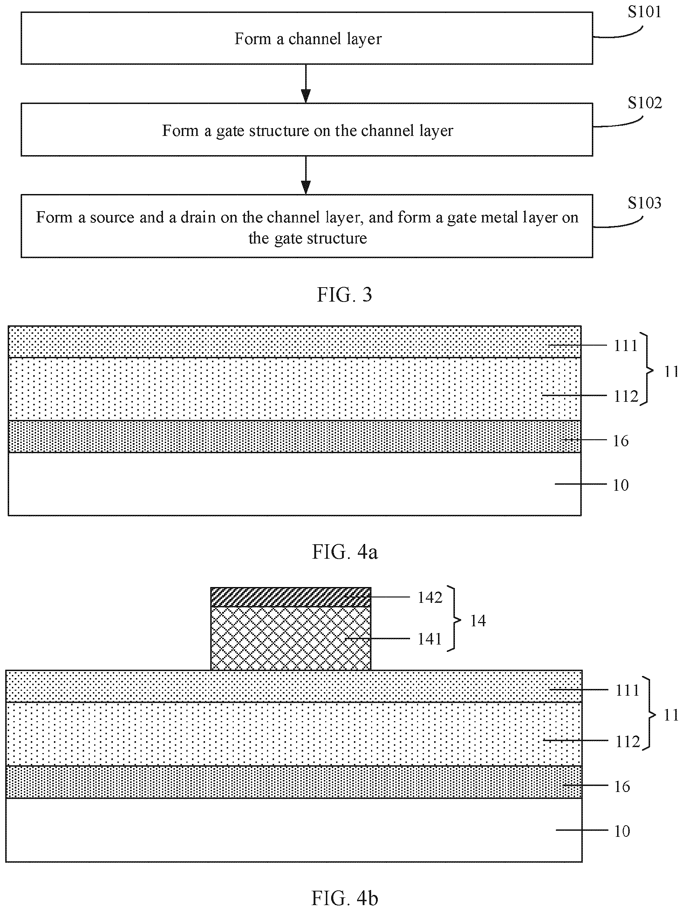

For ease of an understanding of the field effect transistor provided in embodiments of this application, the following describes in detail a method for preparing the field effect transistor with reference to the accompanying drawings. In an embodiment of this application, the field effect transistor may be prepared by using the following preparation method. Refer to FIG. 3. With reference to FIG. 4a to FIG. 4c, FIG. 3 is a schematic flowchart of a method for preparing the field effect transistor according to an embodiment of this application. The method includes the following steps.

Step S101: Form a channel layer.

Optionally, a buffer layer 16 may be first formed on a substrate 10, and a GaN layer 112 and an AlGaN barrier layer 111 are sequentially formed on the buffer layer 16; and the GaN layer 112 and the AlGaN barrier layer 111 form a channel layer 11, thereby forming a structure shown in FIG. 4a.

During specific implementation, the buffer layer 16, the GaN layer 112, and the AlGaN barrier layer 111 may be sequentially staked on the substrate 10 by using a process such as epitaxial growth or deposition.

Step S102: Form a gate structure on the channel layer.

A pGaN layer 141 and an nGaN layer 142 are sequentially formed on the AlGaN barrier layer 111, the pGaN layer 141 and the nGaN layer 142 are etched, and a part of the pGaN layer 141 and a part of the nGaN layer 142 are kept to form a gate structure 14, thereby forming a structure shown in FIG. 4b.

The pGaN layer 141 and the nGaN layer 142 may be sequentially stacked on the AlGaN barrier layer 111 by using a process such as epitaxial growth or deposition.

In the gate structure 14, a doping element of the pGaN layer 141 may be magnesium (Mg), a doping density of the pGaN layer 141 is controlled between 1 × 10¹⁸ cm⁻³ and 1 × 10¹⁹ cm⁻³, a thickness of the pGaN layer 141 may be controlled between 50 nm and 70 nm, a doping element of the nGaN layer 142 may be silicon (Si), germanium (Ge), or the like, a doping density of the nGaN layer 142 may be controlled between 1 × 10¹⁶ cm⁻³ and 5 × 10¹⁹ cm⁻³, and a thickness of the nGaN layer 142 may be less than or equal to 40 nm. In this way, doping densities and thicknesses of the pGaN layer 141 and the nGaN layer 142 are adjusted and controlled, so that a charge storage effect during operation of a device can be reduced, carriers in the pGaN layer 141 are exhausted as much as possible, and redundant-charge storage is avoided, thereby improving operating threshold voltage stability of the device.

Step S103: Form a source and a drain on the channel layer, and form a gate metal layer on the gate structure.

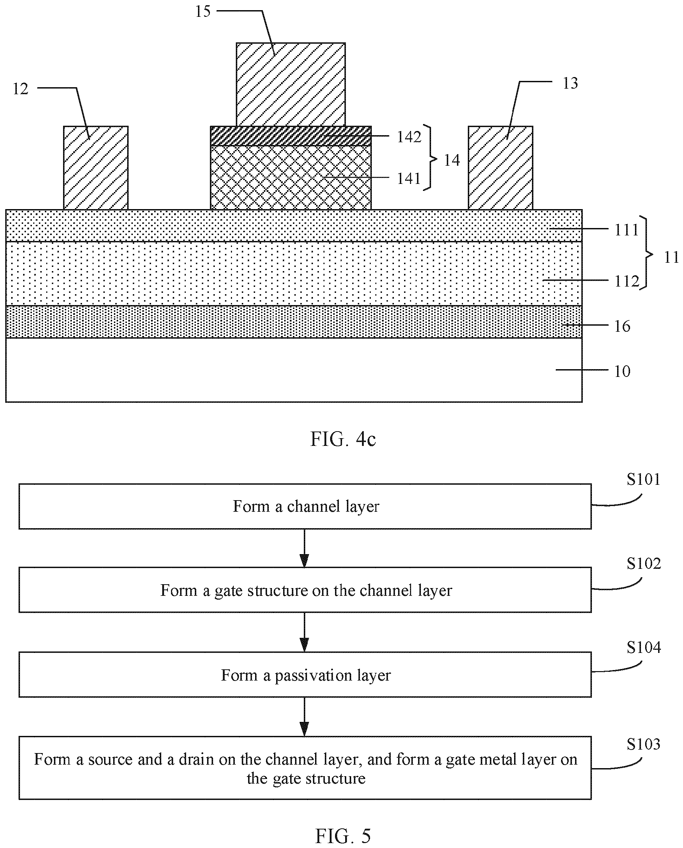

During specific implementation, a metal layer may be formed by using a process such as deposition, and then the metal layer is etched to form the source 12, the drain 13, and a gate metal layer 15; and the source 12 and the drain 13 are located on the AlGaN barrier layer 111, and the gate metal layer 15 is located on the nGaN layer 142 and is in ohmic contact with the nGaN layer 142, to form a structure shown in FIG. 4c.

An nGaN/pGaN reverse bias diode is used to replace a gate metal/pGaN Schottky diode in a current technology to withstand a voltage, so that a gate voltage-withstand capability of the field effect transistor can be greatly increased, thereby improving a breakdown capability of the field effect transistor. The gate metal layer 15 is in ohmic contact with the nGaN layer 142. Forming ohmic contact between metal and a semiconductor means that a pure resistor is at a contact point, and smaller resistance is better, so that when a component is operated, most voltages are applied to an active area instead of a contact surface. In addition, the ohmic contact does not involve long-term thermo-electron bombardment, and is highly reliable. The gate metal layer is in ohmic contact with the gate structure, so that reliability of a connection between the gate metal layer and the gate structure can be improved, thereby improving reliability of the field effect transistor.

During specific implementation, with reference to FIG. 5, after step S102 and before step S103, the method may further include the following step.

Step S104: Form a passivation layer.

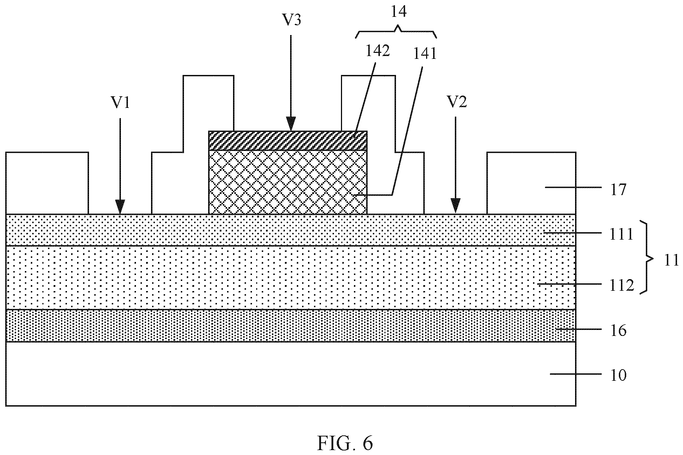

Refer to FIG. 6. A passivation layer 17 covers the gate structure 14 and the AlGaN barrier layer 111 that is exposed, and the passivation layer 17 is etched to form a source contact hole V1, a drain contact hole V2, and a gate contact hole V3.

In this way, the source 12 formed in step S103 is in contact with the AlGaN barrier layer 111 by using the source contact hole V1, the drain 13 is in contact with the AlGaN barrier layer 111 by using the drain contact hole V2, and the gate metal layer 15 is in contact with the nGaN layer 142 by using the gate contact hole V3, to form the field effect transistor shown in FIG. 2.

It can be learned from the foregoing description that, according to the field effect transistor provided in embodiments of this application, a gate voltage-withstand capability of the field effect transistor can be greatly increased by replacing a gate metal/pGaN Schottky diode in a current technology with an nGaN/pGaN reverse bias diode, thereby improving a breakdown capability of the field effect transistor. The gate metal layer is in ohmic contact with the gate structure, so that reliability of a connection between the gate metal layer and the gate structure can be improved, thereby improving reliability of the field effect transistor. Doping densities and thicknesses of the pGaN layer and the nGaN layer are adjusted and controlled, so that a charge storage effect during operation of a device can be reduced, carriers in the pGaN layer are exhausted as much as possible, and redundant-charge storage is avoided, thereby improving operating threshold voltage stability of the device.

An embodiment of this application further provides a switch circuit. The switch circuit may be an AC-DC conversion circuit, a high-voltage conversion circuit, or a switch circuit in a half-bridge rectifier circuit. The switch circuit includes a mainboard and any one of the foregoing field effect transistors provided in embodiments of this application, where the field effect transistor is disposed on the mainboard. A problem-resolving principle of the switch circuit is similar to that of one of the foregoing field effect transistors. Therefore, for implementation of the switch circuit, refer to the implementation of the foregoing field effect transistors. Repeated content is not described again.

It is clear that a person skilled in the art may make various modifications and variations to this application without departing from the spirit and scope of this application. This application is intended to cover these modifications and variations of this application provided that they fall within the scope of protection defined by the claims of this application and their equivalent technologies.

## Claims

1. A field effect transistor, comprising: a channel layer; and a source, a drain, and a gate structure that are disposed in a manner of stacking with the channel layer, wherein the source, the drain, and the gate structure are disposed at a same layer;
the gate structure comprises a P-type gallium nitride layer and an N-type gallium nitride layer that are disposed in a stacking manner, wherein the P-type gallium nitride layer is located between the N-type gallium nitride layer and the channel layer, and a doping density of the P-type gallium nitride layer is between 1 × 10¹⁸ cm⁻³ and 1 × 10¹⁹ cm⁻³; and
the field effect transistor further comprises a gate metal layer, and the gate metal layer is in ohmic contact with the N-type gallium nitride layer.

2. The field effect transistor according to claim 1, wherein a thickness of the P-type gallium nitride layer is greater than or equal to 50 nm and less than or equal to 70 nm.

3. The field effect transistor according to claim 1 or 2, wherein a doping density of the N-type gallium nitride layer is between 1 × 10¹⁶ cm⁻³ and 5 × 10¹⁹ cm⁻³.

4. The field effect transistor according to claim 3, wherein a thickness of the N-type gallium nitride layer is less than or equal to 40 nm.

5. The field effect transistor according to any one of claims 1 to 4, wherein the channel layer comprises a gallium nitride layer and an aluminum gallium nitride barrier layer that are stacked; and
the source, the drain, and the gate structure are disposed at the aluminum gallium nitride barrier layer.

6. The field effect transistor according to claim 5, further comprising a substrate and a buffer layer disposed on the substrate, wherein
the gallium nitride layer is formed on the buffer layer.

7. The field effect transistor according to claim 6, wherein a material of the substrate is silicon, sapphire, silicon carbide, or a gallium nitride body material.

8. The field effect transistor according to any one of claims 5 to 7, further comprising a passivation layer, wherein the passivation layer is disposed in a manner of stacking with the aluminum gallium nitride barrier layer; and
the source, the drain, and the gate structure pass through the passivation layer and are exposed from the passivation layer.

9. A method for preparing a field effect transistor, comprising:
forming a channel layer;
forming a gate structure on the channel layer, wherein the gate structure comprises a P-type gallium nitride layer and an N-type gallium nitride layer that are disposed in a stacking manner, the P-type gallium nitride layer is located between the N-type gallium nitride layer and the channel layer, and a doping density of the P-type gallium nitride layer is between 1 × 10¹⁸ cm⁻³ and 1 × 10¹⁹ cm⁻³; and
forming a source and a drain on the channel layer, and forming a gate metal layer on the gate structure.

10. The preparation method according to claim 9, wherein a thickness of the P-type gallium nitride layer is greater than or equal to 50 nm and less than or equal to 70 nm.

11. A switch circuit, comprising a mainboard and the field effect transistor according to any one of claims 1 to 8, wherein the field effect transistor is disposed on the mainboard.
